Europäisches Patentamt

European Patent Office

Office européen des brevets

(19)

(11) Publication number: 0 293 842 B1

(12)

# EUROPEAN PATENT SPECIFICATION

(45) Date of publication of patent specification: 05.08.92 (51) Int. Cl.⁵: **G01R 15/07**, G01R 31/28

(21) Application number: **88108715.9**

(22) Date of filing: **31.05.88**

(54) **Voltage detector.**

(30) Priority: **31.05.87 JP 137055/87**

(43) Date of publication of application:
**07.12.88 Bulletin  88/49**

(45) Publication of the grant of the patent:
**05.08.92 Bulletin  92/32**

(84) Designated Contracting States:
**DE GB**

(56) References cited:
**DE-A- 3 326 555**
**US-A- 4 253 061**

**PATENT ABSTRACTS OF JAPAN; vol. 6, no. 41 (P-106)[919], 13th March 1982;& JP - A - 56 157 872**

(73) Proprietor: **HAMAMATSU PHOTONICS K.K.**
**1126-1 Ichino-cho Hamamatsu-shi**
**Shizuoka-ken(JP)**

(72) Inventor: **Aoshima, Shinichiro**
**c/o Hamamatsu Photonics K.K. 1126-1,**
**Ichino-cho**
**Hamamatsu-shi Shizuoka(JP)**
Inventor: **Tsuchiya, Yutaka**
**c/o Hamamatsu Photonics K.K. 1126-1,**
**Ichino-cho**
**Hamamatsu-shi Shizuoka(JP)**
Inventor: **Takahashi, Hironori**
**c/o Hamamatsu Photonics K.K. 1126-1,**
**Ichino-cho**
**Hamamatsu-shi Shizuoka(JP)**

(74) Representative: **Patentanwälte Grünecker,**
**Kinkeldey, Stockmair & Partner**
**Maximilianstrasse 58**
**W-8000 München 22(DE)**

EP 0 293 842 B1

## Description

BACKGROUND OF THE INVENTION

The present invention relates to a voltage detector for detecting the voltage developing in a selected area of an object to be measured such as an electric circuit. In particular, the present invention relates to a voltage detector of the type that detects voltage by making use of the change in light polarization that occurs in accordance with the voltage developing in a selected area of an object to be measured.

Various voltage detectors have been used to detect the voltage developing in a selected area of objects to be measured such as electric circuits. Conventional voltage detectors are roughly divided into two types: in one type, the probe is brought into contact with a selected area of an object to be measured and the voltage developing in that area is detected; and in the other type, the probe does not make contact with a selected area of an object to be measured and instead an electron beam is launched into that area and the voltage developing in it is detected.

Voltage changes rapidly in fine-line portions of objects such as integrated circuits that are small and complicated in structure, and a strong need exists in the art for detecting such rapidly changing voltage with high precision without affecting the fine-line portions. However, this need has not been fully met by the prior art voltage detectors. With devices of the type that detects voltage by bringing the probe into contact with a selected area of an object to be measured, it is difficult to attain direct contact between the probe and a fine-line portion of the object of interest such as an integrated circuit. Even if this is successfully done, it has been difficult to correctly analyze the operation of the integrated circuit solely on the basis of the voltage information picked up by the probe. A further problem involved is that contact by the probe can cause a change in the operation of the integrated circuit. Voltage detectors of the type that employs an electron beam has the advantage that they are capable of voltage detection without bringing the probe into contact with an object to be measured. However, the area to be measured with such voltage detectors has to be placed in vacuum and its surface must be exposed at that. In addition, the area to be measured is prone to be damaged by electron beams.

The prior art voltage detectors have a common problem in that they are unable to operate quickly enough to follow rapid changes in voltage and hence fail to achieve precise detection of voltages that change rapidly as in integrated circuits.

With a view to solving these problems, it has been proposed by two of the present inventors (Japanese Patent Application No. 137317/1987 filed on May 30, 1987) that voltage be detected by making use of the polarization of a light beam that changes with the voltage developing in a selected area of an object to be measured.

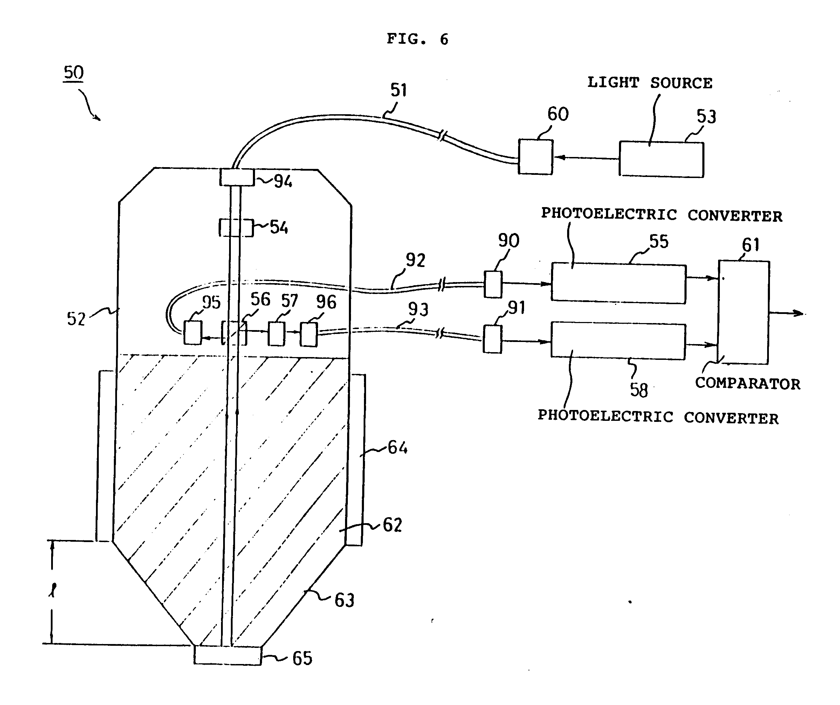

A voltage detector operating on this principle is schematically shown in Fig. 6. The detector generally indicated by 50 is composed of the following components: an optical probe 52; a CW (Continuous-Wave) light source 53 typically in the form of a laser diode; an optical fiber 51 for guiding a light beam from the CW light source 53 into an optical probe 52 via a condenser lens 60; an optical fiber 92 for guiding reference light from the optical probe 52 into a photoelectric converter 55 via a collimator 90; an optical fiber 93 for guiding output light from the optical probe 52 into a photoelectric converter 58 via a collimator 91; and a comparator circuit 61 for comparing the electric signals form the photoelectric converters 55 and 58.

The optical probe 52 is filled with an electro-optic material 62 such as an optically uniaxial crystal of lithium tantalate ($LiTaO_3$). The tip 63 of the electro-optic material 62 is worked into a frustoconical shape. The optical probe 52 is surrounded with a conductive electrode 64 and has at its tip 63 a coating of reflecting mirror 65 in the form of a thin metal film or a multi-layered dielectric film.

The optical probe 52 further includes the following components: a collimator 94; condenser lenses 95 and 96; a polarizer 54 for selectively extracting a light beam having a predetermined polarized component from the light beam passing through the collimator 94; and a beam splitter 56 that splits the extracted light beam from the polarizer 54 into reference light and input light to be launched into the electro-optic material 62 and which allows the output light emerging from the electro-optic material 62 to be directed into an analyzer 57. The reference light is passed through the condenser lens 95 and thence launched into the optical fiber 92, whereas the output light emerging from the electro-optic material 62 is passed through the condenser lens 96 and thence launched into the optical fiber 93.

Voltage detection with the system shown in Fig. 6 starts with connecting the conductive electrode 64 on the circumference of the optical probe 52 to a predetermined potential, say, the ground potential. Then, the tip 63 of the probe 52 is brought close to the object to be measured such as an integrated circuit (not shown), whereupon a change occurs in the refractive index of the tip 63 of the electro-optic material 62 in the probe 52. Stated more specifically, the difference between refractive indices for an ordinary ray and an extraordinary ray in a plane perpendicular to the light-traveling direction will change in the optically uniaxial crystal.

The light beam issuing from the light source 53 passes through the condenser lens 60 and is guided through the optical fiber 51 to be directed into the collimator 94 in the optical probe 52. The beam is polarized by the polarizer 54 and a predetermined polarized component having intensity I is launched into the electro-optic material 62 in the optical probe 52 via the beam splitter 56. Each of the reference light and the input light, which are produced by passage through the beam splitter 56, has an intensity of I/2. As already mentioned, the refractive index of the tip 63 of the electro-optic material 62 varies with the voltage on the object being measured, so the input light launched into the electro-optic material 62 will experience a change in the state of its polarization at the tip 63 in accordance with the change in the refractive index of the latter. The input light is then reflected from the reflecting mirror 65 and makes a return trip through the electro-optic material 62, from which it emerges and travels back to the beam splitter 56. If the length of the tip 63 of the electro-optic material 62 is written as $\ell$, the state of polarization of input light launched into that material will change in proportion to the difference between refractive indices for an ordinary ray and an extraordinary ray and to the length $2\ell$ as well. The output light sent back into the beam splitter 56 is thence directed into the analyzer 57. The intensity of the output light entering the analyzer 57 has been decreased to I/4 as a result of splitting with the beam splitter 56. If the analyzer 57 is designed in such a way as to transmit only a light beam having a polarized component perpendicular to that extracted by the polarizer 54, the intensity of output light that is fed into the analyzer 57 after experiencing a change in the state of its polarization is changed from I/4 to $(I/4)\sin^2[(\pi/2)V/V_0]$ in the analyzer 57 before it is further fed into the photoelectric converter 58. In the formula expressing the intensity of output light emerging from the analyzer 57, V is the voltage developing in the object to be measured, and $V_0$ is a half-wave voltage.

In the comparator circuit 61, the intensity of reference light produced from the photoelectric converter 55, or I/2, is compared with the intensity of output light produced from the other photoelectric converter 58, or $(I/4)\sin^2[(\pi/2)V/V_0]$.

The intensity of output light, or $(I/4)\sin^2[(\pi/2)-V/V_0]$, will vary with the change in the refractive index of the tip 63 of the electro-optic material 62 that occurs as a result of the change in voltage. Therefore, this intensity can be used as a basis for detecting the voltage developing in a selected area of the object to be measured, say, an integrated circuit.

As described above, in using the voltage detector 50 shown in Fig. 6, the tip 63 of the optical probe 52 is brought close to the object to be measured and the resulting change in the refractive index of the tip 63 of the electro-optic material 62 is used as a basis for detecting the voltage developing in a selected area of the object of interest. Therefore, the voltage developing in fine-line portions of a small and complicated object such as an integrated circuit which are difficult to be contacted by a probe or which cannot be contacted by the same without affecting the voltage being measured can be effectively detected by the detector 50 without bringing the optical probe 52 into contact with such fine-line portions. If desired, a pulsive light source such as a laser diode that produces light pulses of a very small pulse width may be used as a light source to ensure that rapid changes in the voltage on the object to be measured are sampled at extremely short time intervals. Rapid changes in the voltage on the object of interest can be measured with a very high time resolution by using a CW light source and a quick-response detector such as a streak camera. Either method is capable of precision detection of rapid changes in voltage.

While various materials are used as electro-optic material 62 in the optical probe 52 for the voltage detector 50 shown in Fig. 6, most of them are birefringent under natural conditions. For example, an optically uniaxial crystal of lithium tantalate ($LiTaO_3$) produces a phase retardation on account of birefringence that occurs spontaneously in proportion to the difference between the refractive index for an ordinary ray $n_o$ and the refractive index for an extraordinary ray $n_e$. This phase retardation occurs even when no voltage is applied to an optically uniaxial crystal and the state of light polarization will change on account of this phase retardation. Therefore, if one wants to detect the voltage on an object of interest precisely by selectively extracting the change in light polarization that results from a change in refractive index upon voltage application, he has to employ a certain means for canceling the phase retardation caused by spontaneous birefringence.

In order to detect the voltage in a selected area of an object of interest with high sensitivity, it is also necessary to reject a dc component from the light emerging from the analyzer 57. Stated more specifically, if the voltage to be measured that develops in an area of interest is a rapidly changing voltage superposed on a dc voltage, one who wants to selectively detect the rapidly changing voltage component must eliminate the change in the state of light polarization that depends on the dc voltage.

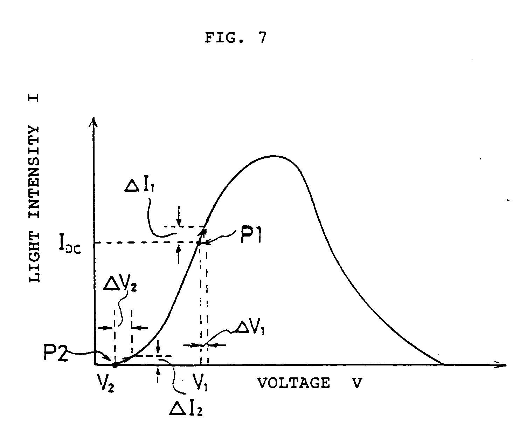

Fig. 7 shows the light intensity I vs. voltage V profile for the case where the analyzer 57 into which the output light emerging from the electro-optic material 62 is introduced is disposed at right angle with respect to the polarizer 54. At operating point P1 on the curve shown in Fig. 7, the change in the intensity of output light, $\Delta I_1$, is linear to the change in voltage $V_1$. However, because of the presence of a dc component $I_{DC}$ in the intensity of output light I, the detector is unable to selectively detect the change in the intensity of output light $\Delta I_1$ with high sensitivity. It is therefore necessary to convert the intensity I of light output from the analyzer 57 in such a way that it will not contain any of the dc component $I_{DC}$ although the change in light intensity $\Delta I_2$ is not linear to the change in voltage $\Delta V_2$ as depicted by operating point P2 on the curve shown in Fig. 7.

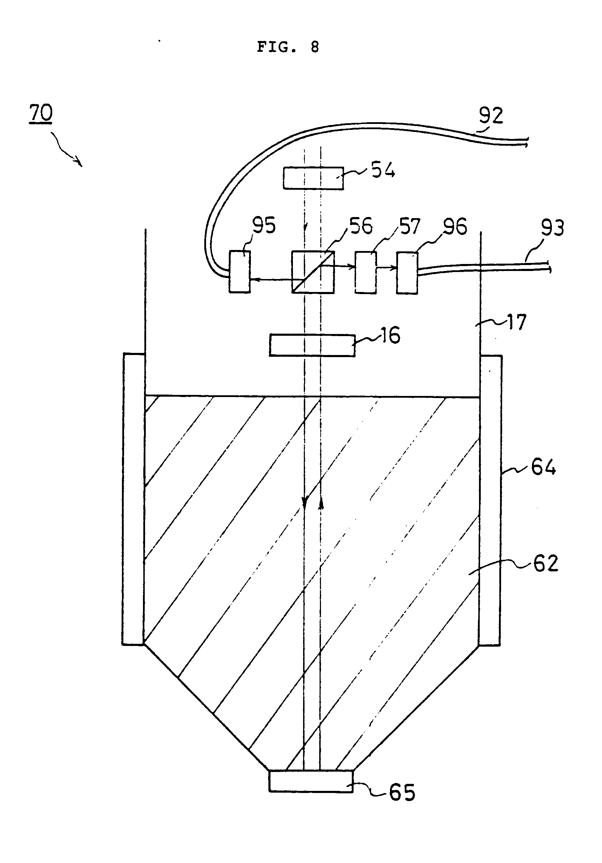

To meet this need, a voltage detector having the construction shown in Fig. 8 and which is generally indicated by 70 was previously proposed by the present inventors.

The optical probe 17 for the voltage detector 70 shown in Fig. 8 differs from the probe 52 shown in Fig. 6 in that it has a phase compensator 16 between the beam splitter 56 and the electro-optic material 62. By properly adjusting this phase compensator 16, the change in the state of polarization of output light produced from the electro-optic material 62 can be reduced to such a level that it originates only from the voltage applied to the electro-optic material 62. In other words, in detecting the voltage in a selected area of an object to be measured, the phase compensator 16 may be adjusted in such a way that in the absence of any voltage applied to the electro-optic material 62, the polarized component of the output light produced from said material is directed perpendicular to that of input light (launched into that material), and with the least intensity of output light being produced from the analyzer 57. By adjusting the phase compensator 16 in this way, it becomes possible to cancel the change in the state of polarization of output light that is caused by the phase retardation due to the spontaneous birefringence occurring in the electro-optic material 62.

The phase compensator 16 used for this purpose may be a Soleil compensator capable of mechanical adjustment or a Babinet compensator which is suitable for the case where a small-diameter spot is produced by light beam. A Soleil compensator is equipped with a sliding adjustment mechanism that allows for adjustment from the outside of the optical probe 17. Before detection of the voltage in a selected area of an object to be measured, the adjustment mechanism is operated, usually manually, with no voltage applied to the electro-optic material 62, so as to eliminate the effect of phase retardation caused by spontaneous birefringence.

If the phase compensator 16 is of the voltage adjustable type, the dc component $I_{DC}$ can be rejected from the intensity of output light from the analyzer 57 by first applying a given voltage to the compensator 16 and then adjusting it manually in such a way that it will operate at point P2 on the curve shown in Fig. 7.

The problem is that the phase retardation caused by spontaneous birefringence occurring in the electro-optic material 62 is temperature-dependent and varies with the change in the temperature of the optical probe 17, or the environment in which the electro-optic material 62 is used. The intensity of output light at operating point P2 on the curve shown in Fig. 7 also varies with temperature change. It should particularly be mentioned that at operating point P2 the intensity of output light varies nonlinearly, so that a variation in the intensity of output light on account of temperature change can cause a significant effect on the precision of voltage detection. Therefore, even if the phase compensator 16 used in the voltage detector 70 shown in Fig. 8 is manually adjusted to a predetermined value prior to voltage detection, the initial setting will become no longer appropriate in the phase of subsequent changes in temperature and correct results cannot be attained over the entire period of voltage detection.

## SUMMARY OF THE INVENTION

An object, therefore, of the present invention is to provide a voltage detector of simple structure that closely follows temperature changes so as to eliminate any adverse effects thereof and which is capable of detecting the voltage in a selected area of an object of interest at all times with high precision and sensitivity.

The present invention is basically intended as an improvement of a voltage detector of the type that employs an electro-optic material whose refractive index will change according to the voltage developing in a selected area of an object to be measured.

A voltage detector according to the first aspect of the present invention includes a first electro-optic material means that is subject to the effect of the voltage developing in a selected area of an object to be measured and a second electro-optic material means that is disposed in such a way as to compensate for the phase retardation caused by spontaneous birefringence occurring in the first electro-optic material means. The second electro-optic material means is made of the same material as the first electro-optic material means and has the same length as the latter in the light-traveling direction with the two electro-optic material means aligned along the light-traveling direction.

A voltage detector according to the second aspect of the present invention further includes a first transparent electrode between the first and second electro-optic materials, as well as a second transparent electrode disposed on the side of the second electro-optic material which is opposite to the side where the first transparent electrode is disposed. The first transparent electrode is connected to a predetermined potential, say, the ground potential. A predetermined, preferably variable, voltage is applied to the second transparent electrode.

Other and further objects, features and advantages of the invention will appear more fully from the following description taken in connection with the accompanying drawings.

BRIEF DESCRIPTION OF THE DRAWINGS

Fig. 1 is a diagram showing the composition of a voltage detector according to an embodiment of the first aspect of the present invention;
Fig. 2 is a diagram showing part of the composition of a voltage detector according to a modification of the concept shown in Fig. 1;
Fig. 3 is a diagram showing part of the composition of a voltage detector according to an embodiment of the second aspect of the present invention;
Fig. 4 is a diagram showing the composition of a complete system employing the voltage detector shown in Fig. 3;
Fig. 5 is a diagram showing part of the composition of a voltage detector according to a modification of the concept shown in Figs. 3 and 4;
Fig. 6 is a diagram showing the composition of a voltage detector having been proposed in Japanese Patent Application No.137317/1987;
Fig. 7 is a graph showing the voltage dependency of the intensity of output light; and
Fig. 8 is a diagram showing the composition of a voltage detector equipped with a phase compensating plate.

DETAILED DESCRIPTION OF THE PREFERRED EMBODIMENTS

Various embodiments of the present invention are described hereinafter with reference to the accompanying drawings.

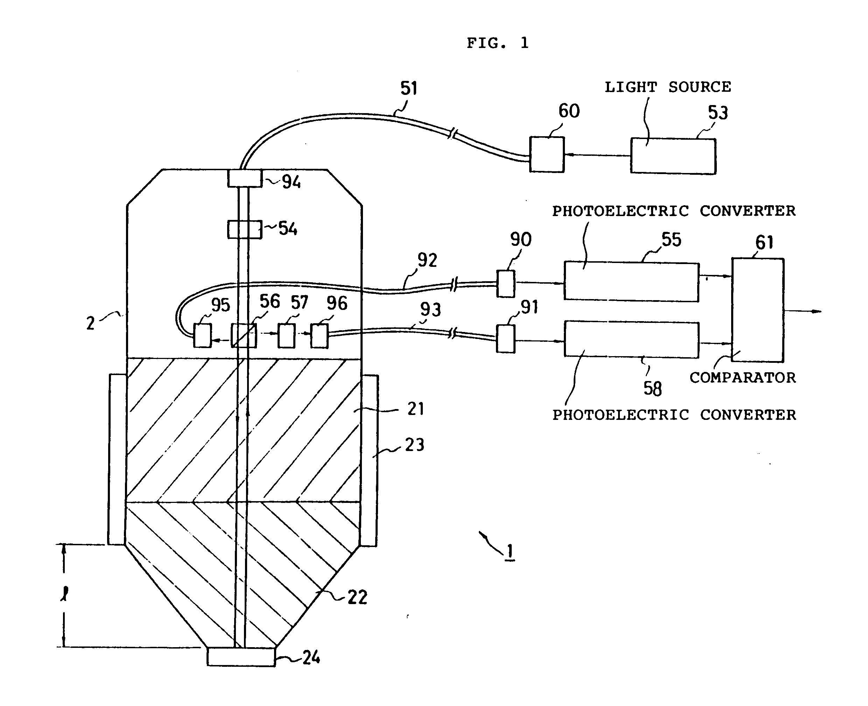

Fig. 1 is a diagram showing the composition of a voltage detector according to one embodiment of the first aspect of the present invention. In Fig. 1, components which are the same as those shown in Figs. 6 and 8 are identified by like numerals and redundant explanation is omitted.

The voltage detector generally indicated by 1 in Fig. 1 has the following components installed in an optical probe 2 as in the optical probes 52 and 17 shown in Figs. 6 and 8, respectively: a collimator 94; condenser lenses 95 and 96; a polarizer 54; a beam splitter 56; and an analyzer 57. Instead of the electro-optic material 62 in the optical probes 52 and 17 shown in Figs. 6 and 8, two electro-optic materials 21 and 22 are packed in the optical probe 2 of the voltage detector 1. The two electro-optic materials 21 and 22 are made of entirely the same material (i.e., an optically uniaxial crystal) and have the same length in the light-traveling direction. In the embodiment shown in Fig. 1, the two electro-optic materials 21 and 22 are disposed in such a way that their optic axes are perpendicular to each other.

The electro-optic material 21 is surrounded completely, and the electro-optic material 22 is surrounded partly, with a conductive electrode 23. The electro-optic material 22 has at its tip a coating of reflecting mirror 24 in the form of a thin metal film or a multi-layered dielectric film. The conductive electrode 23 is connected to the ground potential. Since no electric field will be produced within the electro-optic material 21, its refractive index will not change according to the voltage developing in a selected area of an object being measured. Therefore, the state of polarization of a light beam traveling through the electro-optic material 21 will change solely on account of the phase retardation caused by spontaneous birefringence occurring in said material 21.

On the other hand, the refractive index of the electro-optic material 22 will change on account of the difference between the potential induced in the reflecting mirror 24 by the voltage in a selected area of the object being measured and the ground potential to which the conductive electrode 23 is connected. Therefore, the state of polarization of a light beam traveling through the electro-optic material 22 will change not only in response to the voltage in a selected area of the object being measured but also on account of the phase retardation caused by spontaneous birefringence occurring in the material 22.

As already mentioned, the optic axes of the electro-optic materials 21 and 22 are perpendicular to each other, so the change, due to spontaneous birefringence, of the state of polarization of the light beam passing through the electro-optic material 21 is in a direction opposite to that of the light beam passing through the electro-optic material 22.

In the voltage detector 1 having the construction described above, a light beam having a predetermined polarized component which is produced from the polarizer 54 as its output is passed through the beam splitter 56 and thence launched as input light into the electro-optic material 21. The launched light experiences a change in the state of its polarization on account of the phase retardation caused by spontaneous birefringence occurring in the electro-optic material 21, and is thereafter launched in the electro-optic material 22.

As already mentioned, the electro-optic materials 21 and 22 are of equal length in the light-traveling direction, so the input light, when launched into the electro-optic material 22, will experience a change in the state of its polarization on account of the phase retardation caused by spontaneous birefringence occurring in this material and the direction of this change is opposite to that in which the same phenomenon occurs in the electro-optic material 21. In addition, the state of polarization of the input light also changes as a result of the change in refractive index occurring on account of the potential of the reflecting mirror 24. Therefore, when the input light reaches the reflecting mirror 24, the state of its polarization has changed in accordance with the change in the refractive index of the electro-optic material 22 that occurs on account of the voltage developing in a selected area of the object being measured, and the effect of the phase retardation due to spontaneous birefringence has been rejected from the change in the state of polarization of the input light.

When the light reflected from the reflecting mirror 24 travels back through the electro-optic materials 22 and 21 to emerge therefrom as output light, the change in the state of its polarization on account of the phase retardation caused by spontaneous birefringence is canceled by entirely the same mechanism as described above, and the output light when it emerges from the electro-optic material 21 has undergone a further change in the state of polarization in accordance with the change in the refractive index of the electro-optic material 22 that occurs on account of the voltage developing in a selected area of the object being measured. Therefore, the state of polarization of the output light (emerging from the electro-optic material 21) which is directed into the analyzer 57 has changed from the state of polarization of the input light that was produced by splitting with the beam splitter 56, and this change does not contain any of the effects of phase retardation that are caused by spontaneous birefringence occurring in the electro-optic materials.

As described above, in the embodiment shown in Fig. 1 according to the first aspect of the present invention, the electro-optic material 22 which is subject to the effect of the voltage occurring in a selected area of the object to be measured is disposed in such a way that its optic axis is perpendicular to that of the electro-optic material 21 which is made of entirely the same material as 22 and which is also equal in length to the latter in the light-traveling direction. In addition, the voltage detector 1 is so set up that no electric field will be produced in the electro-optic material 21. As a result, the change in the state of polarization of a light beam passing through the electro-optic material 22 on account of the phase retardation caused by spontaneous birefringence is canceled by the change in the state of light polarization on account of the phase retardation caused by spontaneous birefringence in the electro-optic material 21, and the state of polarization of output light to be directed into the analyzer 57 from the electro-optic material 21 can be changed from the state of polarization of input light by an amount solely dependent on the voltage applied to the electro-optic material 22.

The voltage detector 1 shown in Fig. 1 has the following advantages over the detector 70 shown in Fig. 8: first, it does not require any cumbersome step such as adjusting the phase compensator 16 prior to voltage detection; secondly, even if the environmental temperature changes, the phase retardation due to the spontaneous birefringence in the electro-optic material 21 changes in entirely the same way as the phase retardation due to the spontaneous birefringence in the electro-optic material 22, thereby canceling at all times the change in the state of light polarization due to the phase retardation caused by spontaneous birefringence.

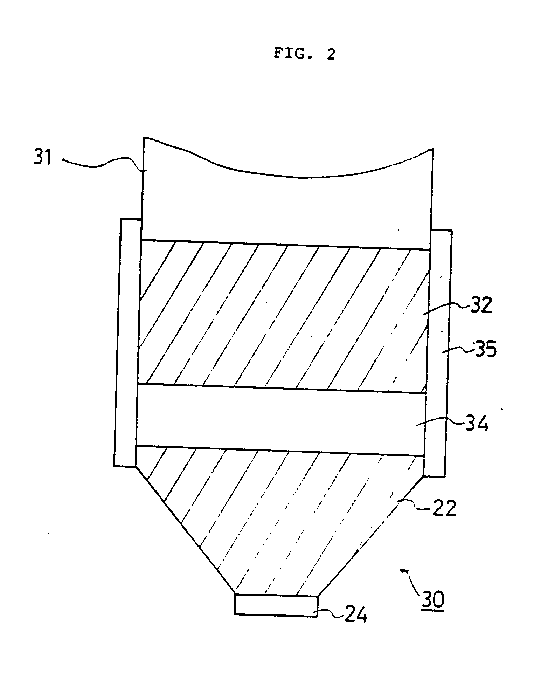

Fig. 2 shows a modification of the voltage detector 1 shown in Fig. 1. The voltage detector generally indicated by 30 in Fig. 2 contains two electro-optic materials 22 and 32 and a half-wavelength ($\lambda$/2) plate 34. The electro-optic material 32 is made of the same material (optically uniaxial crystal) as the electro-optic material 21 used in the voltage detector 1 shown in Fig. 1 and it has the same length as the electro-optic material 22 in the light-traveling direction. However, the electro-optic material 32 is disposed in such a way that its optic axis is parallel to that of the electro-optic material 22. The $\lambda$/2 plate 34 is disposed between the two electro-optic materials 32 and 22 and has following two capabilities: changing the polarizing direction of input light from the electro-optic material 32 by 90° before it is launched into the electro-optic material 22; and in a like manner, changing the polarizing direction of output light from the electro-optic material 22 by 90° before it is launched into the electro-optic material 32. This change of polarizing direction of 90° is caused by the phase retardation of $\pi$ between an ordinary ray and an extraordinary ray in the $\lambda$/2 plate 34. In short, the voltage detector 30 shown in Fig. 2 differs from the detector 1 shown in Fig. 1 in that the $\lambda$/2 plate 34 is inserted between the electro-optic materials 32 and 22 instead of making their optic axes perpendicular to each other.

In the embodiment shown in Fig. 2, the electro-optic material 32 and the λ/2 plate 34 are surrounded entirely, and the electro-optic material 22 surrounded partly, with a conductive electrode 35. As in the voltage detector 1 shown in Fig. 1, the conductive electrode 35 is connected to the ground potential so that no electric field will be produced within the electro-optic material 32.

In the voltage detector 30 having the construction described above, input light launched into the electro-optic material 32 experiences a change in the state of its polarization on account of the phase retardation caused by spontaneous birefringence taking place in the electro-optic material 32. The light then enters the λ/2 plate 34 where its polarizing direction changes by 90° before it is launched into the electro-optic material 22. Since the λ/2 plate 34 changes the polarizing direction by 90°, the input light launched into the electro-optic material 22 will experience a change in the state of its polarization on account of the phase retardation due to spontaneous birefringence occurring in that material and the direction of this change is opposite to that of the change occurring in the electro-optic material 32. The light launched into the electro-optic material 22 will experience a further change in the state of its polarization on account of the change in refractive index caused by the voltage on the object being measured. Therefore, when the launched light reaches the reflecting mirror 24, the state of its polarization has changed in accordance with the change in the refractive index of the electro-optic material 22 that occurs on account of the voltage on the object of interest, and the resulting change in the state of polarization of the launched light does not contain any of the effects of the phase retardation due to spontaneous birefringence.

When the light reflected from the reflecting mirror 24 travels back through the electro-optic materials 22 and 32 to emerge therefrom, the change in the state of its polarization on account of the phase retardation caused by spontaneous birefringence is canceled by entirely the same mechanism as described above, and the light when it emerges from the electro-optic material 32 has undergone a further change in the state of polarization in accordance with the change in the refractive index of the electro-optic material 22 that occurs on account of the voltage on the object being measured. Therefore, the state of polarization of the output light which is directed into the analyzer 57 has changed from the state of polarization of the input light, and this change does not contain any of the effects of phase retardation that are caused by spontaneous birefringence occurring in the electro-optic materials.

As described above, the voltage detector 30 shown in Fig. 2 has the λ/2 plate 34 inserted between the electro-optic materials 32 and 22 which are disposed in such a way that their optic axes are parallel to each other. Since this plate changes the polarizing direction by 90°, the change in the state of polarization of a light beam passing through the electro-optic material 22 on account of the phase retardation caused by spontaneous birefringence can be canceled by the change in the state of light polarization on account of the phase retardation caused by spontaneous birefringence in the electro-optic material 32, and the state of polarization of output light to be directed into the analyzer 57 from the electro-optic material 32 can be changed from the state of polarization of reference light by an amount solely dependent on the voltage applied to the electro-optic material 22.

As in the embodiment shown in Fig. 1, the voltage detector 30 shown in Fig. 2 does not require any cumbersome pre-adjustments and the effects of phase retardation caused by birefringence occurring in the two electro-optic materials can be canceled at all times in spite of changes in the environmental temperature, thereby ensuring precise detection of the voltage in a selected area of the object being measured.

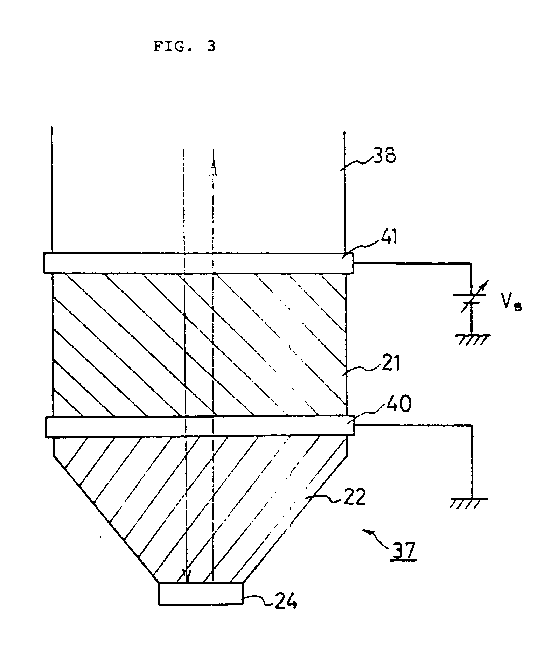

Fig. 3 is a diagram showing part of the composition of an embodiment according to the second aspect of the present invention. As in the voltage detector 1 shown in Fig. 1, the optical probe 38 of the voltage detector generally indicated by 37 in Fig. 3 contains two electro-optic materials 21 and 22 that are of equal length in the light-traveling direction and which are disposed in such a way that their optic axes are perpendicular to each other. In the embodiment shown in Fig. 3, the probe 38 further includes a transparent electrode 40 between the two electro-optic materials 21 and 22, as well as another transparent electrode 41 disposed on the side of the electro-optic material 21 which is opposite to the side where the transparent electrode 40 is disposed.

The transparent electrode 40 is designed to permit the launching of input light from the electro-optic material 21 into 22 while permitting the transmission of output light from electro-optic material 22 to 21. The transparent electrode 41 is designed to permit the launching of input light from beam splitter 56 into electro-optic material 21 while permitting the transmission of output light from electro-optic material 21 into beam splitter 56 and thence into analyzer 57. During use of the voltage detector 37, the transparent electrode 40 is connected to the ground potential while the transparent electrode 41 is supplied with a variable voltage $V_B$.

In other words, the voltage detector 37 shown in Fig. 3 is designed in such a way that the refractive index of the electro-optic material 22 will vary in accordance with the potential difference between the voltage on the object being measured and the ground potential to which the transparent electrode 40 is connected, while the refractive index of the electro-optic material 21 will vary in accordance with the potential difference between the variable voltage $V_B$ applied to the transparent electrode 41 and the ground potential to which the transparent electrode 40 is connected. The transparent electrode 40 is disposed parallel to the reflecting mirror 24 so that the lines of electric force extending from the object of interest through the reflecting mirror 24 will run into the electro-optic material 22 parallel to its central axial line. As a result, a uniform change in refractive index will occur at all positions in the electro-optic material 22. In a like manner, the transparent electrode 41 is disposed parallel to the transparent electrode 40, so that the lines of electric force running into the electro-optic material 21 will extend parallel to its central axial line, thereby creating a uniform change in refractive index at all positions in the electro-optic material 21.

As in the voltage detector 1 shown in Fig. 1, the two electro-optic materials 21 and 22 in the voltage detector 37 shown in Fig. 3 are of equal length in the light-traveling direction and their optic axes are perpendicular to each other. Therefore, the effects of phase retardation caused by spontaneous birefringence occurring in the two electro-optic materials 21 and 22 can be canceled by each other at all times in spite of variations in the environmental temperature. Another feature of the voltage detector 37 is that a predetermined voltage $V_B$ is applied to the transparent electrode 41 so as to cause a given change in the refractive index of the electro-optic material 21. This allows the operating point of the detector to be shifted from points P1 to P2 on the curve shown in Fig. 7, thereby rejecting a dc component from the state of polarization of the output light emerging from the electro-optic material 22. If the environmental temperature changes, there occurs a corresponding change in the intensity of output light at operating point P2. In the embodiment shown in Fig. 3, voltage $V_B$ is automatically changed in accordance with temperature change and the operating point P2 is slightly shifted to compensate for the variation in the intensity of output light due to temperature change. Stated more specifically, when a certain change occurs in the environmental temperature, voltage $V_B$ is automatically changed to cause a corresponding change in the refractive index of the electro-optic material 21 so that the intensity of output light will not fluctuate with temperature.

As described above, the voltage detector 37 shown in Fig. 3 has the advantage that the phase retardation caused by the spontaneous birefringence occurring in the electro-optic material 22 can be canceled at all times by the electro-optic material 21. In addition, the variable voltage $V_B$ applied to the transparent electrode 41 enables the operating point of the detector to be set in such a way as to reject a dc component from the intensity of output light, while compensating for the detector at all times of its operation in such a way that the intensity of output light from which a dc component has been eliminated will not fluctuate in the face of temperature change.

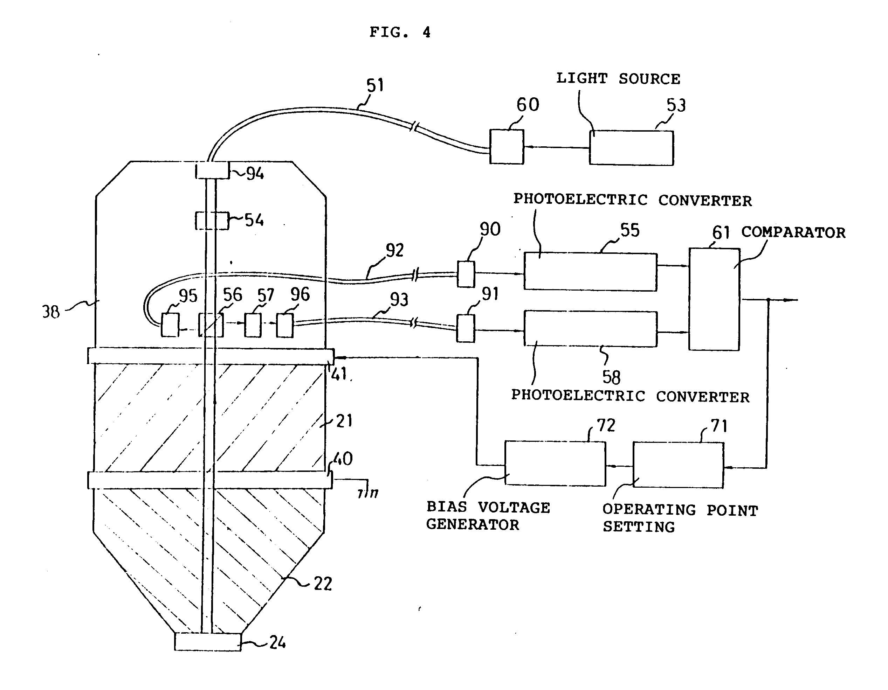

Fig. 4 is a diagram showing the composition of a complete system employing the voltage detector 37 shown in Fig. 3.

In the system shown in Fig. 3, an electrical signal from the comparator circuit 61 is supplied to an operating point setting circuit 71. Any change in the electrical signal output produced from the comparator circuit 61 on account of a temperature change is detected by the operating point setting circuit 71, and then a bias voltage generator circuit 72 will supply the transparent electrode 41 with a voltage that cancels the detected change. If the intensity of output light contains a superposed dc component, the operating point is reset by allowing the bias voltage generator circuit 72 to supply the transparent electrode 41 with a voltage that will reject such dc component. By performing this feedback control, it is possible to attain output light whose intensity is free from a dc component and will not fluctuate in the face of temperature changes.

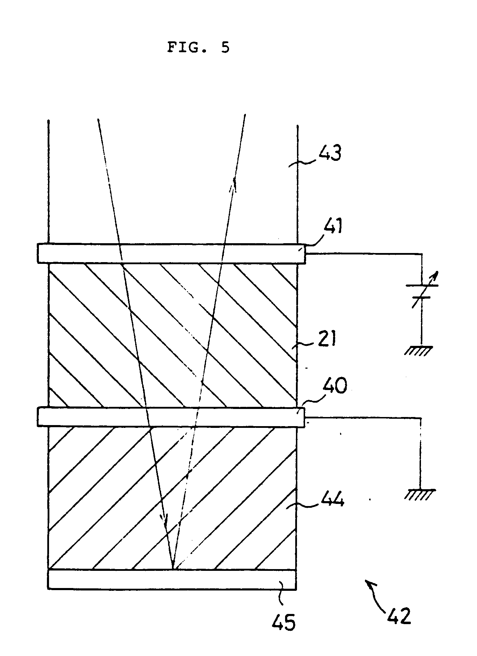

Fig. 5 is a diagram showing a modification of the voltage detector depicted in Figs. 3 and 4. In this modification, an electro-optic material 44 which takes on the same cylindrical form as the electro-optic material 21 is used in place of the frustoconical electro-optic material 22 shown in Figs. 3 and 4, and the tip of this electro-optic material 44 is provided with a reflecting mirror 45 in the form of a thin metal film or a multi-layered dielectric film. With the arrangement shown in Fig. 5, input light is completely reflected from the reflecting mirror 45 so as to produce output light whose intensity is substantially the same as that of the input light. If the input light is allowed to travel on a different optical path than the output light as shown in Fig. 5, the latter can be picked up without employing a beam splitter.

In the embodiments shown in Figs. 3 to 5, the two electro-optic materials are arranged in such a way that their optic axes are perpendicular to each other as in the embodiment shown in Fig. 1. If desired, a λ/2 plate may be disposed between these two electro-optic materials as in the case shown in Fig. 2, with their optic axes being disposed parallel to each other.

When a streak camera is used as the detector, it is sometimes the case that the reference light is not used.

In practical applications, it is recommended that each of the optical probes 2, 31, 38 and 43 used in the above-described embodiments is provided with black coating on an inner surface of a light-splitting and extracting part and outer surfaces of the electro-optic materials in order to prevent scattering of an incident light beam.

As described on the foregoing pages, a first electro-optic material that is subject to the voltage developing in a selected area of an object to be measured is used in the voltage detector of the present invention in combination with a second electro-optic material specifically intended to compensate for the phase retardation occurring on account of spontaneous birefringence. This eliminates the need to perform any cumbersome pre-adjustments for the purpose of compensating for unwanted phase retardation. In addition, the phase retardation caused by spontaneous birefringence can be effectively compensated at all times in spite of changes in the environmental temperature and this allows for precise detection of the voltage on the object of interest. In accordance with another aspect of the present invention, a first transparent electrode is provided between the first and second electro-optic materials, and a second transparent electrode is formed on the side of the second electro-optic material which is opposite to the side where the first transparent electrode is disposed. If the intensity of output light contains a dc component, it can be eliminated by applying a certain voltage to the second transparent electrode. If a variable voltage is applied, the output light which has been freed of its dc component can be compensated in such a way that its intensity will not vary with temperature, thereby enabling the voltage on the object of interest to be detected with high precision and sensitivity.

## Claims

1. A voltage detector (1) for detecting a voltage developing in a selected area of an object to be measured, comprising:
   a light source (53) for emitting a light beam;
   a voltage-sensing part including a reflection means (24, 45) for reflecting an input light beam, a first electro-optic material means (22, 44) whose refractive index changes according to said voltage developing in said selected area of said object, and a second electro-optic material means (21, 32) whose refractive index is not affected by said voltage of said object, wherein said first (22, 44) and second (21, 32) electro-optic material means are made of the same material, and are disposed in such a manner that said first (22, 44) and second (21, 32) electro-optic material means are aligned along a light-traveling direction with their lengths in said light-traveling direction being substantially identical;
   splitting and extracting means (56) for extracting a light beam with a first predetermined polarized component from a light beam introduced from said light source which is launched into said second electro-optic material means (21, 32) as said input light beam, and extracting an output light beam with a second predetermined polarized component from an output light beam emerging from said second electro-optic material means (21, 32) after reflecting from said reflection means (24, 45); and
   detection means (55, 58, 61) for determining said voltage developing in said selected area of said object on the basis of intensity of said output light beam with said second predetermined polarized component.

2. A voltage detector as claimed in Claim 1, wherein
   said splitting and extracting means (56) further splits said light beam with said first predetermined polarized component into a reference light beam and said input light beam which is launched into said second electro-optic material means (21, 32); and
   said detection means determines said voltage on the basis of intensity of said reference light beam and intensity of said output light beam with said second predetermined polarized component.

3. A voltage detector as claimed in Claim 1, wherein said first (22, 44) and second (21) electro-optic material means are aligned in such a manner that the optic axes of said first and second electro-optic material means are perpendicular to each other.

4. A voltage detector as claimed in Claim 1, further comprising:
   an optical means (34) for rotating a polarizing direction of light by 90 degrees which is disposed between said first (22) and second (32) electro-optic material means, wherein
   said first (22) and second (32) electro-optic material means are aligned in such a manner that the optic axes of said first and second electro-optic material means are parallel to each other.

**5.** A voltage detector as claimed in Claim 4, wherein said optical means (34) for rotating said polarizing direction is a λ/2 plate.

**6.** A voltage detector as claimed in Claim 1, wherein said voltage-sensing part further includes an electrode (23, 35) which surrounds said second (21, 32) electro-optic material means and is connected to a ground potential.

**7.** A voltage detector as claimed in Claim 1, further comprising:

a first transparent electrode (40) disposed between said first (22, 44) and second (21) electro-optic material means; and

a second transparent electrode (41) disposed on a side of said second electro-optic material means (21) which is opposite to a side where said first transparent electrode (40) is disposed.

**8.** A voltage detector as claimed in Claim 7, wherein said first transparent electrode (40) is connected to a ground potential, and said second transparent electrode (41) is supplied with a voltage so that a dc component of said second predetermined polarization component of said output light can be eliminated.

**9.** A voltage detector as claimed in Claim 7, wherein said first transparent electrode (40) is connected to a ground potential, and said second transparent electrode (41) is supplied with a variable voltage so that a dc component of said second predetermined polarization component of said output light caused by a temperature variation can be eliminated.

**10.** A voltage detector as claimed in Claim 7, wherein said first (22) and second (21) electro-optic material means are aligned in such a manner that the optic axes of said first and second (21) electro-optic materials are perpendicular to each other.

**11.** A voltage detector as claimed in Claim 7. further comprising:

an optical means (34) for rotating an polarizing direction of light by 90 degrees which is disposed between said first (22) and second (32) electro-optic material means, wherein

said first (22) and second (32) electro-optic material means are aligned in such a manner that optic axes of said first (22) and second (32) electro-optic material means are parallel to each other.

**12.** A voltage detector as claimed in Claim 7, wherein said reflection means (24), first (40) and second (41) transparent electrodes are disposed in such a manner that they are all perpendicular to said light-traveling direction and are parallel to one another.

**13.** A voltage detector as claimed in Claim 1, wherein an inner surface of said splitting and extracting means (56) and outer surfaces of said first (22, 44) and second (21, 32) electro-optic material means are provided with black coating.

**Revendications**

**1.** Détecteur de tension (1) pour détecter une tension qui se développe dans une zone sélectionnée d'un objet qui doit être mesuré, comprenant :

une source de lumière (53) pour émettre un faisceau de lumière ;

une partie de détection de tension incluant un moyen de réflexion (24, 45) pour réfléchir un faisceau de lumière d'entrée, un premier moyen de matériau électro-optique (22, 44) dont l'indice de réfraction varie en fonction de ladite tension qui se développe dans ladite zone sélectionnée dudit objet, et un second moyen de matériau électro-optique (21, 32) dont l'indice de réfraction n'est pas affecté par ladite tension dudit objet, dans laquelle lesdits premier (22, 44) et second (21, 32) moyens de matériau électro-optique sont réalisés à partir du même matériau et sont disposés d'une manière telle que lesdits premier (22, 44) et second (21, 32) moyens de matériau électro-optique soient alignés le long d'une direction du trajet de la lumière, leurs longueurs suivant ladite direction de trajet de la lumière étant sensiblement identiques ;

un moyen de séparation et d'extraction (56) pour extraire un faisceau de lumière comportant une première composante polarisée prédéterminée à partir d'un faisceau de lumière introduit depuis ladite source de lumière qui est émis dans ledit second moyen de matériau électro-optique (21, 32) en tant que faisceau de lumière d'entrée, et pour extraire un faisceau de lumière de sortie comportant une Seconde composante polarisée prédéterminée d'un faisceau de lumière de sortie qui émerge dudit second moyen de matériau électro-optique (21, 32) après réflexion depuis ledit moyen de réflexion (24, 45) ; et

un moyen de détection (55, 58, 61) pour déterminer ladite tension qui se développe dans ladite zone sélectionnée dudit objet sur la base d'une intensité dudit faisceau de lumière de sortie comportant ladite seconde composante polarisée prédéterminée.

2. Détecteur de tension selon la revendication 1, dans lequel :

ledit moyen de séparation et d'extraction (56) sépare en outre ledit faisceau de lumière comportant ladite première composante polarisée prédéterminée en un faisceau de lumière de référence et en ledit faisceau de lumière d'entrée qui est émis dans ledit second moyen de matériau électro-optique (21, 32) ; et

ledit moyen de détection détermine ladite tension sur la base d'une intensité dudit faisceau de lumière de référence et d'une intensité dudit faisceau de lumière de sortie comportant ladite seconde composante polarisée prédéterminée.

3. Détecteur de tension selon la revendication 1, dans lequel lesdits premier (22, 44) et second (21) moyens de matériau électro-optique sont alignés d'une manière telle que les axes optiques desdits premier et second moyens de matériau électro-optique soient perpendiculaires l'un à l'autre.

4. Détecteur de tension selon la revendication 1, comprenant en outre :

un moyen optique (34) pour faire tourner une direction de polarisation de la lumière de 90 degrés, ce moyen étant disposé entre lesdits premier (22) et second (32) moyens de matériau électro-optique, dans lequel

lesdits premier (22) et second (32) moyens de matériau électro-optique sont alignés d'une manière telle que les axes optiques desdits premier et second moyens de matériau électro-optique soient parallèles l'un à l'autre.

5. Détecteur de tension selon la revendication 4, dans lequel ledit moyen optique (34) pour faire tourner ladite direction de polarisation est une plaque demi-longueur d'onde.

6. Détecteur de tension selon la revendication 1, dans lequel ladite partie de détection de tension inclut en outre une électrode (23, 35) qui entoure ledit second (21, 32) moyen de matériau électro-optique et qui est connectée à un potentiel de masse.

7. Détecteur de tension selon la revendication 1, comprenant en outre :

une première électrode transparente (40) disposée entre lesdits premier (22, 44) et second (21) moyens de matériau électro-optique ; et

une seconde électrode transparente (41) disposée sur un côté dudit second moyen de matériau électro-optique (21) qui est opposé à un côté où ladite première électrode transparente (40) est disposée.

8. Détecteur de tension selon la revendication 7, dans lequel ladite première électrode transparente (40) est connectée à une potentiel de masse et ladite seconde électrode transparente (41) se voit appliquer une tension de telle sorte qu'une composante continue de ladite seconde composante de polarisation prédéterminée de ladite lumière de sortie puisse être éliminée.

9. Détecteur de tension selon la revendication 7, dans lequel ladite première électrode transparente (40) est connectée à un potentiel de masse et ladite seconde électrode transparente (41) se voit appliquer une tension variable de telle sorte qu'une composante continue de ladite seconde composante de polarisation prédéterminée de ladite lumière de sortie générée par une variation de température puisse être éliminée.

10. Détecteur de tension selon la revendication 7, dans lequel lesdits premier (22) et second (21) moyens de matériau électro-optique sont alignés d'une manière telle que les axes optiques desdits premier et second (21) matériaux électro-optiques soient perpendiculaires l'un à l'autre.

11. Détecteur de tension selon la revendication 7, comprenant en outre :

un moyen optique (34) pour faire tourner une direction de polarisation de la lumière de 90 degrés, ce moyen étant disposé entre lesdits premier (22) et second (32) moyens de matériau électro-optique, dans lequel lesdits premier (22) et second (32) moyens de matériau électro-optique sont alignés d'une manière telle que les axes optiques desdits premier (22) et second (32) moyens de matériau électro-optique soient parallèles l'un à l'autre.

12. Détecteur de tension selon la revendication 7, dans laquel ledit moyen de réflexion (24), lesdites première (40) et seconde (41) électrodes transparentes sont disposées d'une manière telle qu'ils sont tous perpendiculaires à ladite direction de trajet de la lumière et qu'ils sont parallèles les uns aux autres.

13. Détecteur de tension selon la revendication 1, dans lequel une surface interne dudit moyen de séparation et d'extraction (56) et des surfaces externes desdits premier (22, 44) et second (21, 32) moyens de matériau électro-optique sont munis d'un revêtement noir.

**Patentansprüche**

1. Ein Spannungsdetektor (1) zur Erfassung einer in einem bestimmten Bereich eines zu messenden Objekts auftretenden Spannung mit:
einer einen Lichtstrahl aussendenden Lichtquelle (53);
einem spannungsempfindlichen Teil mit einem Reflektor (24, 65) zur Reflektion eines einfallenden Lichtstrahls, mit einem ersten elektro-optischen Material (22, 44), dessen Brechungsindex sich entsprechend zu einer in dem bestimmten Bereich des Objekts entwickelnden Spannung verändert, und mit einem zweiten elektro-optischen Material (21, 22), dessen Brechungsindex durch die in dem Objekt auftretende Spannung nicht beeinflußbar ist, wobei das erste (22, 44) und zweite (21, 32) elektro-optische Material aus dem gleichen Material besteht, und so angeordnet ist, daß das erste (22, 44) und zweite (21, 32) elektro-optische Material entlang der Lichtfortpflanzungsrichtung angeordnet ist und deren Längen in dieser Richtung im wesentlichen identisch sind;
einer Aufspalt- und Ausblendeinrichtung (56) zum Ausblenden eines Lichtstrahls von einem von der Lichtquelle eingegebenen Lichtstrahl mittels einer ersten vorbestimmt polarisierten Komponente, wobei der Lichtstrahl in das zweite elektro-optische Material (21, 32) als Einfallslichtstrahl eingegeben wird, und zum Ausblenden eines ausfallenden Lichtstrahls mittels einer zweiten vorbestimmt polarisierten Komponente aus dem ausfallenden Lichtstrahl, der aus dem zweiten elektro-optischen Material (21, 32) nach Reflektion durch den Reflektor (24, 45) austritt; und
einem Detektor (55, 58, 61) zur Bestimmung der in dem ausgewählten Bereich des Objekts auftretenden Spannung aufgrund der Intensität des ausfallenden Lichtstrahls mit der zweiten vorbestimmt polarisierten Komponente.

2. Spannungsdetektor nach Anspruch 1, **dadurch gekennzeichnet,** daß die Aufspalt- und Ausblendeinrichtung (56) den Lichtstrahl mit der ersten vorbestimmt polarisierten Komponente in einen Referenzlichtstrahl und den Einfallslichtstrahl aufspaltet, welcher in das zweite elektro-optische Material (21, 32) einfällt; und daß der Detektor die Spannung aufgrund der Intensität des Referenzlichtstrahls und der Intensität des Ausgangslichtstrahls mit der zweiten vorbestimmt polarisierten Komponente erfaßt.

3. Spannungsdetektor nach Anspruch 1, **dadurch gekennzeichnet,** daß das erste (22, 44) und zweite (21) elektro-optische Material mit ihren optischen Achsen senkrecht zueinander angeordnet sind.

4. Spannungsdetektor nach Anspruch 1, **dadurch gekennzeichnet,** daß der Spannungsdetektor eine optische Einrichtung (34) zur Drehung der Polarisationsrichtung des Lichts um 90° umfaßt, welche zwischen dem ersten (22) und zweiten (32) elektro-optische Material angeordnet ist, wobei das erste (22) und zweite (32) elektro-optische Material mit ihren optischen Achsen parallel zueinander angeordnet sind.

5. Spannungsdetektor nach Anspruch 4, **dadurch gekennzeichnet,** daß die optische Einrichtung (34) zur Drehung der Polarisationsrichtung ein λ/2-Plättchen ist.

6. Spannungsdetektor nach Anspruch 1, **dadurch gekennzeichnet,** daß der spannungsempfindliche Teil weiterhin eine Elektrode (23, 35) umfaßt, welche das zweite elektro-optische Material (21, 32) umgibt und mit dem Erdpotential verbunden ist.

7. Spannungsdetector nach Anspruch 1, **dadurch gekennzeichnet,** daß der Spannungsdetektor weiterhin umfaßt:
eine erste, transparente Elektrode (40), die zwischen dem ersten (22, 44) und zweiten (21) elektro-optischen Material angeordnet ist; und eine zweite transparente Elektrode (41), die auf einer Seite des zweiten elektro-optischen Materials (21) angeordnet ist, die der Seite gegenüberliegt, auf der die erste transparente Elektrode (40) angeordnet ist.

8. Spannungsdetektor nach Anspruch 7, **dadurch gekennzeichnet,** daß die erste transparente Elektrode (40) mit dem Erdpotential verbunden ist und die zweite transparente Elektrode (41) mit einer Spannung versorgt ist, so daß eine Gleichspannungskomponente der zweiten vorbestimmt polarisierten Komponente des ausfallenden Lichts eliminiert werden kann.

9. Spannungsdetector nach Anspruch 7, **dadurch gekennzeichnet,** daß die erste transparente Elektrode (40) mit dem Erdpotential verbunden ist und die zweite transparente Elektrode (41) mit einer veränderlichen Spannung versorgt ist, so daß eine Gleichspannungskomponente der zweiten vorbestimmt polarisierten Komponente des ausfallenden Lichts, die durch Temperaturveränderungen hervorgerufen wird, eliminiert werden kann.

10. Spannungsdetektor nach Anspruch 7, **dadurch gekennzeichnet,** daß das erste (22) und zweite (21) elektro-optische Material mit seinen optischen Achsen senkrecht zueinander angeordnet ist.

11. Spannungsdetector nach Anspruch 7, **dadurch gekennzeichnet,** daß der Spannungsdetektor weiterhin umfaßt:
eine optische Einrichtung (34) zur Drehung einer Polarisationsrichtung des Lichts um 90°, die zwischen dem ersten (22) und zweiten (32) elektro-optischen Material angeordnet ist, wobei das erste (22) und zweite (32) elektro-optische Material mit seinen optischen Achsen parallel zueinander angeordnet ist.

12. Spannungsdetektor nach Anspruch 7, **dadurch gekennzeichnet,** daß der Reflektor (24), die erste (40) und zweite (41) transparente Elektrode so angeordnet sind, daß sie alle senkrecht zur Lichtfortpflanzungsrichtung und parallel zueinander angeordnet sind.

13. Spannungsdetektor nach Anspruch 1, **dadurch gekennzeichnet,** daß eine innere Oberfläche der Aufspalt- und Ausblendeinrichtung (56) und eine äußere Oberfläche des ersten (22, 44) und zweiten (21, 32) elektro-optischen Materials mit einem schwarzen Überzug versehen sind.

# FIG. 1

FIG. 2

FIG. 3

FIG. 4

FIG. 5

EP 0 293 842 B1

## FIG. 6

LIGHT SOURCE

PHOTOELECTRIC CONVERTER

PHOTOELECTRIC CONVERTER

COMPARATOR

FIG. 7

FIG. 8